# FASCICULE DE BREVET EUROPEEN

(11) **EP 1 801 968 B1**
(45) Date de publication et mention de la délivrance du brevet: **27.01.2010**
(21) Numéro de dépôt: 06126162.4
(22) Date de dépôt: 14.12.2006
(51) Int. Cl.: H03H 11/32, H03F 1/56, H03F 3/60

(54) **Structure de balun à large bande passante**
Breitband-Balunstruktur
Broadband balun structure

(30) Priorité: 21.12.2005 FR 0513000
(43) Date de publication de la demande: 27.06.2007
(73) Titulaire: Thales, 92200 Neuilly-sur-Seine (FR)
(72) Inventeur: Dueme, Philippe, 91400, ORSAY (FR); Plaze, Jean-Philippe, 78390, BOIS D'ARCY (FR)
(74) Mandataire: Lucas, Laurent Jacques

(56) Documents cités:
- EP-A2- 0 196 098
- US-A- 5 920 230
- FRANK B M ET AL: "Performance of 1-10-GHz Traveling Wave Amplifiers in 0.18 um CMOS" IEEE MICROWAVE AND WIRELESS COMPONENTS LETTERS, IEEE SERVICE CENTER, NEW YORK, NY, US, vol. 12, no. 9, septembre 2002 (2002-09), XP011066898 ISSN: 1531-1309

## Description

### DOMAINE DE L'INVENTION

L'invention concerne le domaine des dispositifs électroniques connus sous le nom de "baluns", et plus particulièrement le domaine des mélangeurs à large bande passante, employés notamment dans les chaînes d'émission et de réception radioélectriques, et réalisés à partir de baluns.

### CONTEXTE DE L'INVENTION - ART ANTERIEUR

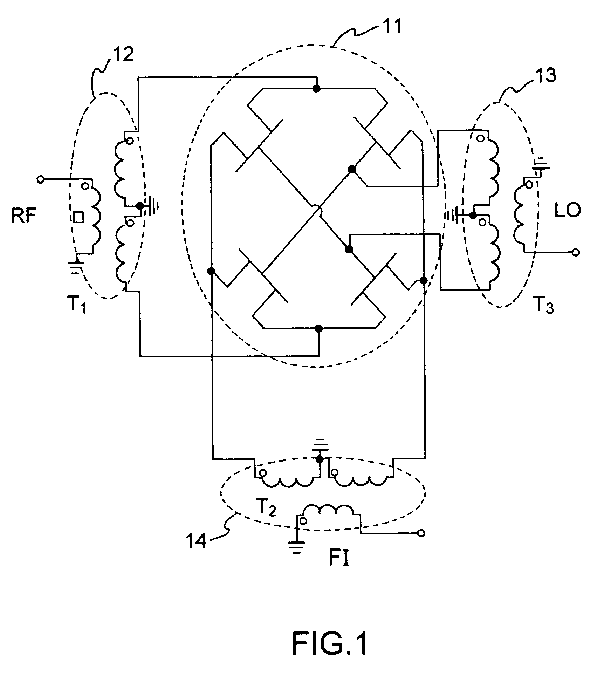

Lorsque l'on veut réaliser un dispositif mélangeur tel que celui dont le schéma de principe est représenté sur la figure 1, il est connu d'utiliser des composants non linéaires tels que des diodes ou des transistors pour réaliser des structures de préférence équilibrées ou doublement équilibrées. Par structure équilibrée on entend une structure ayant pour caractéristiques de fonctionner à partir d'ondes différentielles c'est à dire en utilisant 2 signaux de même amplitude mais en opposition de phase (cas des structures simplement équilibrées) ou à partir de 2 paires d'ondes différentielles (cas des structures doublement équilibrées). Cela permet alors d'éliminer en sortie certains battements indésirables du signal d'entrée et / ou du signal provenant de l'oscillateur local.
La mise sous forme différentielle de ces signaux est généralement réalisée, lorsqu'il s'agit de montages électroniques à base de composants discrets, par l'intermédiaire de structures passives de type transformateur à double enroulement et à point milieu, ou transformateur différentiel. Ces structures présentent l'avantage d'être à large bande et de ne nécessiter aucune alimentation. Ce sont des circuits passifs idéals et réciproques, qui peuvent donc être utilisés aussi bien en entrée qu'en sortie de mélangeur. En revanche, ce sont des structures par nature encombrante, un transformateur comportant nécessairement des conducteurs bobinés formant un certain nombre de spires autour d'un élément magnétisable, un noyau de ferrite par exemple. Ce sont en outre des structures dont la bande passante est limitée au domaine des basses fréquences, typiquement à quelques centaines de MHz.

C'est pourquoi lorsque l'on souhaite réaliser un dispositif mélangeur intégré à structure monolithique, à large bande passante, en technologie MMIC ("**M**onolithic **M**icrowave **I**ntégrated **C**ircuit" selon la terminologie anglo-saxonne) par exemple, il faut avoir recours à des structures différentes pour attaquer les entrées/sorties du mélangeur. Dans ce cadre il est connu d'utiliser des structures appelées baluns large bande.

Le terme "balun" qui est une contraction de l'expression anglo-saxonne "balanced - unbalanced" désigne de manière générale un dispositif à trois accès capable soit de diviser un signal d'entrée en deux signaux de sortie de même amplitude et déphasés entre eux de 180°, et de réaliser ainsi un circuit diviseur de puissance avec sorties en opposition de phase, soit de recombiner deux signaux d'entrée de sorte que le signal de sortie représente la différence des signaux d'entrée et de réaliser alors un circuit combineur avec entrées en opposition de phase.

Dans le domaine des hyper fréquences, ces éléments (diviseur et combineur) peuvent être passifs et réalisés au moyen de structures constituées de lignes de transmission couplées. On parle alors de baluns passifs. Les baluns passifs présentent l'avantage d'être réciproques. En revanche, ils présentent l'inconvénient d'avoir une bande passante par construction limitée et un encombrement fonction de la longueur d'onde moyenne du signal traité.

Ces éléments peuvent également être des éléments actifs basés sur une structure distribuée constituée de transistors couplant activement 2 lignes de transmission artificielles. On parle alors de baluns actifs.

Les baluns actifs présentent de manière connue l'avantage d'offrir potentiellement une bande passante plus large, et de présenter un certain gain. La publication de B. M. Frank & Al (IEEE Microwave and wireless components Letters, vol.12, N°9, September 2002) ainsi que la demande de brevet Européen EP0196098 déposée par la sté Honeywell Inc. et publiée le 01/10/1986, présentent, notamment, des structures comportant de cellules amplificatrices réparties le long d'une ligne de transmission, permettant de réaliser de tels baluns actifs.

En revanche les baluns actifs connus de l'art antérieur présentent l'inconvénient de ne pas être réciproques. La réalisation de diviseurs et combineurs au moyen de baluns actifs conduit donc à associer à un mélangeur un étage différentiel d'entrée différent de l'étage différentiel de sortie. Les modèles connus de baluns actifs à structure distribuée permettent de réaliser des circuits combineurs et des circuits diviseurs de puissance pouvant être associés à un circuit mélangeur. Ces modèles comportent des cellules constituées de montages à transistors en configuration "grille commune" ou "source commune" suivant qu'ils constituent la voie de référence ou la voie en opposition de phase. Quoi que remplissant globalement la fonction de diviseur ou de combineur souhaitée, ces modèles présentent généralement un double inconvénient :
- d'une part ils sont difficiles à équilibrer. Les gains des deux voies sont sensiblement différents, de sorte que l'équilibrage est généralement réalisé en limitant le gain de la voie de plus grand gain, ce qui a pour effet de limiter sensiblement le gain qu'il est possible d'obtenir avec de tels modèles.
- d'autre part, l'adaptation radioélectrique des entrées de tels modèles est difficile à réaliser.
   Ces deux inconvénients ont en particulier pour conséquence de rendre délicate la réalisation de manière aisément reproductible de circuits mélangeurs à baluns actifs, sous forme MMIC.

### PRESENTATION DE L'INVENTION

Un but de l'invention est notamment de pallier les inconvénients présentés par l'utilisation des modèles de baluns connus en particulier dans les mélangeurs en technologie MMIC. A cet effet l'invention a pour objet un dispositif balun à large bande passante comportant trois lignes formant deux structures amplificatrices distribuées, chaque structure comportant une ligne commune avec l'autre structure,. Chaque structure est constituée de cellules élémentaires comportant chacune deux inductances en série sur la ligne commune et deux autres inductances en série sur l'autre ligne formant la structure, ainsi qu'un élément actif amplificateur relié d'une part au point commun des inductances en série sur la ligne commune et d'autre part au point commun des inductances en série sur l'autre ligne formant la structure. Selon l'invention, le dispositif balun à large bande passante caractérisé en ce que l'élément actif amplificateur de la première structure est constitué de deux transistors agencés pour former un montage de type "Darlington" et que l'élément actif amplificateur de la seconde structure est constitué de deux transistors agencés pour former un montage de type "Cascode". Les deux structures fournissent ainsi des signaux en opposition de phase l'un par rapport à l'autre.

Selon un mode de réalisation de l'invention, l'élément actif de la première structure est constitué de deux transistors à effet de champ en configuration "source commune" et dans lequel l'élément actif de la deuxième structure (41, 43) est constitué d'un transistor en configuration "source commune" et d'un transistor à effet de champ en configuration "grille commune".

Selon un mode de réalisation de l'invention, l'élément actif de la première structure, est constitué de deux transistors bipolaires en configuration "Emetteur commun" et l'élément actif de la deuxième structure est constitué d'un transistor en configuration "Emetteur commun" et d'un transistor à effet de champ en configuration "Base commune".

Selon l'invention, les transistors constituant les étages d'adaptation sont montés de façon à ce que chacune des structures soit constituée d'une ligne de grille et d'une ligne de drain, les deux lignes étant couplées de manière active par les générateurs de courant formés par les circuits de sortie des montages à transistors qui constituent les cellules

L'invention présente en particulier pour l'avantage de masquer les différences d'impédance d'entrée entre les deux structures amplificatrices distribuées constituant le balun, différence que l'on peut constater au niveau du balun actif classique. Ces différences d'impédance sont notamment responsables de l'existence d'un biais sur le déphasage entre signaux, et d'une différence de gain entre les chaines d'amplification que constituent les deux structures.

Avantageusement le dispositif selon l'invention peut aussi bien être réalisé au moyen de transistors à effet de champ, qu'au moyen de transistors bipolaire. Dans ce dernier cas, les montages "grille commune" sont remplacés par des montages "base commune" et les montages "source commune" sont remplacés par des montages "émetteur commun".

### DESCRIPTION DES FIGURES

Les caractéristiques de l'invention ainsi que ses avantages sont clairement présentés dans la description qui suit, description illustrée par les figures annexées qui représentent :
la figure 1, un schéma de principe de mélangeur équilibré comportant des structures différentielles en entrée/sortie,
la figure 2, le schéma de principe d'un balun passif et réciproque, utilisé en hyperfréquence, et connu sous le nom de balun de Marchand,
la figure 3, un exemple de réalisation, en technologie MMIC, d'un balun de Marchand, au moyen d'éléments de circuits imprimés,
les figures 4 et 6, les schémas de principe de deux types de baluns actifs pris comme exemples, réalisés à partir de structures distribuées connues de l'art antérieur,
les figures 5 et 7, les schémas de principe des deux types de baluns actifs correspondants, réalisés selon l'invention,
les figures 8 et 9, les courbes relatives à des simulations réalisées respectivement sur un balun diviseur et sur un balun combineur selon l'invention.

### DESCRIPTION DETAILLEE

La description du dispositif selon l'invention est ici réalisée au travers de l'application particulière à un mélangeur. Cette application qui sert de support à la description n'est bien entendu nullement limitative.

On s'intéresse dans un premier temps à la figure 1. Cette figure représente le schéma électrique de principe d'un montage mettant en oeuvre un mélangeur équilibré 11, ici un pont de transistors à effet de champ, ou FET (pour "Field Effect Transistor") selon la dénomination anglo-saxonne. Ce mélangeur permet en particulier d'effectuer une transposition de fréquence d'un signal radioélectrique (ou signal "RF") en un signal de plus basse fréquence (ou signal "FI") en combinant ce signal avec un signal fourni par exemple par un oscillateur local (signal "LO"). Il permet également la transposition inverse d'un signal "FI" en signal "RF". Ce mélangeur équilibré étant conçu pour effectuer le mélange de signaux flottants, il est nécessaire si l'on veut effectuer le mélange de signaux référencés, par rapport à la masse du montage par exemple, d'utiliser des éléments différentiels 12, 13 et 14 en entrée et en sortie du mélangeur. Si l'on considère un montage électronique classique réalisé à partir de composants discrets, les éléments différentiels les plus utilisés sont des transformateurs comportant un enroulement primaire T₁ et deux enroulements secondaires identiques T₂ et T₃ dont les bornes sont connectées de façon à générer deux tensions en opposition de phase.
Réaliser ces éléments différentiels au moyen de transformateurs présente beaucoup d'avantages. Cela permet en particulier de disposer d'éléments facilement reproductibles et de faible coût. Ce sont en outre des éléments qui présentent l'avantage de disposer d'une bande passante satisfaisante et d'être des éléments passifs réciproques qui peuvent donc effectuer aussi bien la transformation d'un signal référencé à la masse en signal différentiel comme les éléments 12 et 13 de la figure que la transformation inverse comme l'élément 14.
En revanche de tels éléments sont relativement lourds et encombrants de sorte qu'il n'est pas facile de les miniaturiser. De plus, s'agissant d'éléments comportant des lignes couplées par l'intermédiaire d'un noyau de ferrite la fréquence de fonctionnement maximale du noyau de ferrite, typiquement quelques centaines de MHz, limite leur plage de fonctionnement aux basses fréquences et interdit leur utilisation dans le domaine des hyperfréquences. Ce sont en outre des éléments qu'il n'est par nature pas possible de réaliser au sein d'un circuit intégré monolithique. Leur emploi est donc peu compatible de l'utilisation d'une technologie de type MMIC. D'autre part, s'agissant d'éléments passifs ces transformateurs ne procurent aucun gain sur le signal.

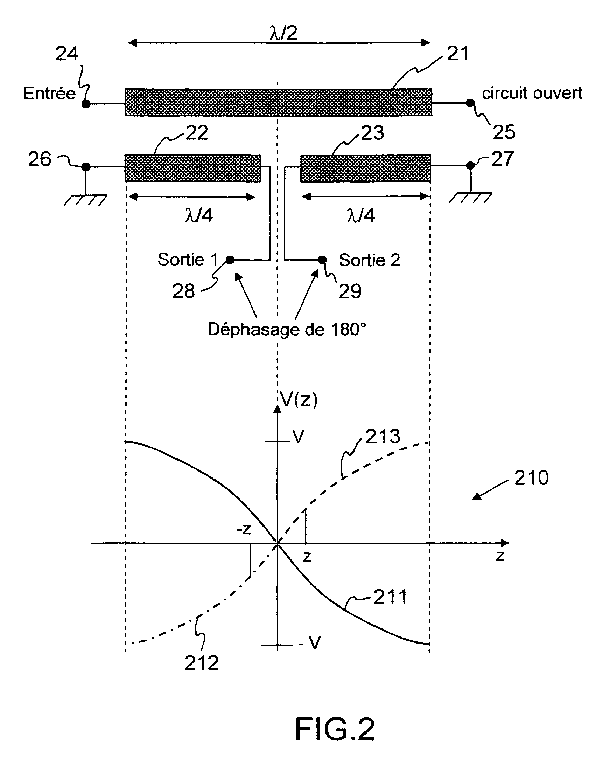

Pour réaliser des mélanges de signaux à très haute fréquence une méthode connue consiste à utiliser non plus des transformateurs, difficiles à réaliser aux très hautes fréquences, mais des lignes couplées, généralement réalisées sous la forme de pistes imprimées sur un substrat semi-conducteur de type arséniure de Gallium par exemple. La figure 2 propose le schéma de principe de tels éléments, connus de l'homme du métier sous la dénomination de "baluns de Marchand". On rappelle que comme il a été dit précédemment, le terme "balun" est une contraction de l'expression anglo-saxonne "balanced-unbalanced".
Comme l'illustre la figure 2, un tel balun se compose principalement d'une ligne principale 21 à laquelle sont couplées deux lignes identiques 22 et 23 La ligne principale 21 a une longueur sensiblement égale à la moitié (λ|2) de la longueur d'onde λ correspondant à la fréquence centrale du signal appliqué sur l'entrée 24. L'extrémité opposée 25 de la ligne principale 21 est par ailleurs laissée ouverte.
Les deux lignes couplées 22 et 23 ont une longueur égale à λ/4. Chacune des lignes a une extrémité, 26 ou 27, connectée à la masse du circuit dont elles font partie, les autres extrémités 28 et 29 constituant les sorties du balun. La disposition des lignes 22 et 23 est en outre optimisée de façon à ce que les sorties 28 et 29 présentent des signaux en opposition de phase. De manière connue, on obtient ainsi entre les deux sorties 28 et 29 un signal différentiel (ou flottant) d'amplitude 2V. L'évolution de la tension couplée mesurée sur chacune des deux lignes 22 et 23, en fonction de la position du point de mesure sur la ligne est illustrée sur le diagramme de la figure 210. Sur ce diagramme les courbes 212 et 213 représentent la valeur de la tension présente respectivement sur les lignes 22 et 23, la courbe 211 représentant quant à elle la tension le long de la ligne principale 21. On peut constater à l'étude de ce diagramme que pour deux points quelconques situés chacun sur une des lignes 22 ou 23, à une même distance z de l'extrémité mise en court circuit de la ligne correspondante, les tensions mesurées à un instant donné sont de signes opposés. Elles présentent donc bien, de manière connue, un déphasage de 180°.

Le balun passif de type "Marchand", constitué par des lignes de transmission de longueurs déterminées présente l'avantage d'être simple à réaliser. Il présente également l'avantage, comme tout montage passif d'être par nature réciproque. En revanche, il présente l'inconvénient de tout coupleur passif d'avoir des dimensions adaptées à une longueur d'onde précise et qu'il cesse de fonctionner de manière correcte sitôt que l'on s'éloigne du voisinage de cette longueur d'onde. Un tel dispositif ne peut donc pas être utilisé pour des applications en large bande c'est à dire pour des signaux dont la fréquence s'étale sur plusieurs octaves.

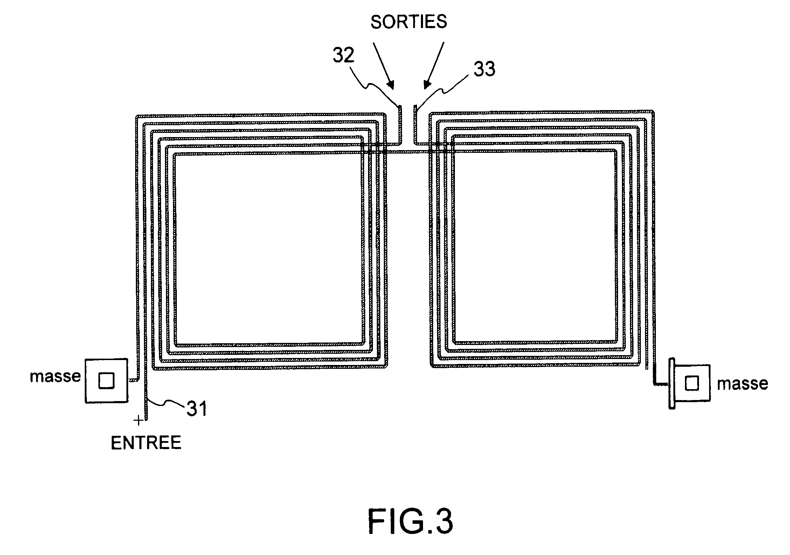

En outre, aux fréquences basses, ces structures à base de lignes de dimension égales à la demi-longueur d'onde λ/2 du signal, présentent un encombrement important et ne sont donc pas compatibles avec des technologies MMIC. Ainsi, par exemple, pour une fréquence égale à 2 GHz, la demi-longueur d'onde, λ/2, mesure 26,4 mm ce qui représente une taille trop importante pour être intégrée dans un circuit MMIC.
Une solution connue pour contourner cet inconvénient lié à la taille du dispositif, consiste à réaliser une structure de lignes couplées en forme de spirales telle que celle illustrée par la figure 3

De tels baluns, réalisés à partir de spirales imbriquées, ont pour des fréquences relativement élevées, de l'ordre de quelques GHz par exemple, une taille qui permet leur intégration dans un circuit MMIC. Ils présentent en outre une bande passante relativement large et permettent de réaliser des baluns passifs dont la bande passante s'étend par exemple de 2GHz à 12GHz. Cependant les pertes restent importantes, la surface très grande, les adaptations médiocres en particulier en ce qui concerne les sorties couplées 32 et 33. La précision du déphasage entre les signaux présents sur les sorties est en outre limitée, l'erreur commise autour de la valeur souhaitée étend d'environ une quinzaine de degrés.

Face aux solutions utilisant des dispositifs passifs à base de lignes de transmission, il est possible de réaliser des baluns à l'aide de composants actifs. Une solution connue consiste à utiliser des structures distribuées actives. L'avantage d'une structure distribuée active est de générer du gain et de réaliser des circuits très large bande avec un encombrement minimal. Le principe de fonctionnement des structures distribuées actives, principe connu de l'homme du métier, n'est pas détaillé ici. De telles structures sont notamment décrites dans les documents suivants :
- [1] L. B. Beyer, S. N. Prasad, R. C. Becker, J. E. Nordman, G. K. Hohenwarter, Y. Chen "Wideband Monolithic Microwave Amplifier Study" - Rapport de l'université de Wisconsin-Madison pour le gouvernement US, 1983
- [2] A. M. Pavio, R. H. Halladay, S. D. Bingham, C. A. Sapashe - "Double Balanced Mixers Using Active and Passive Techniques" - IEEE transactions on microwave theory and techniques, vol 36, n°12, 1988.

Pour réaliser un balun au moyen de structures actives distribuées, qui par nature ne sont pas des structures réciproques, il convient d'envisager les deux fonctionnalités pouvant être réalisées par un balun passif.

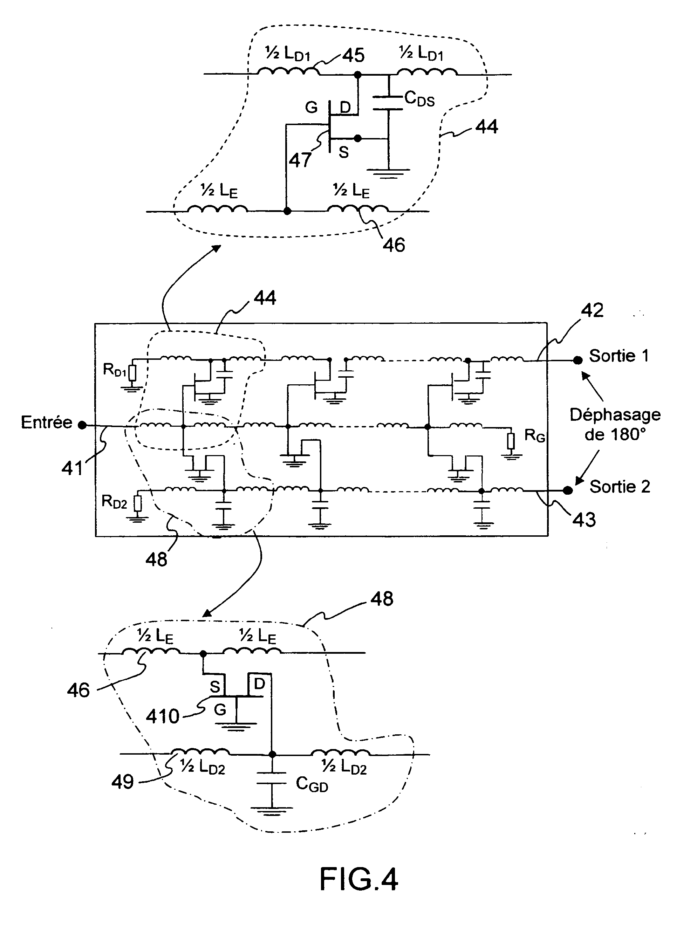

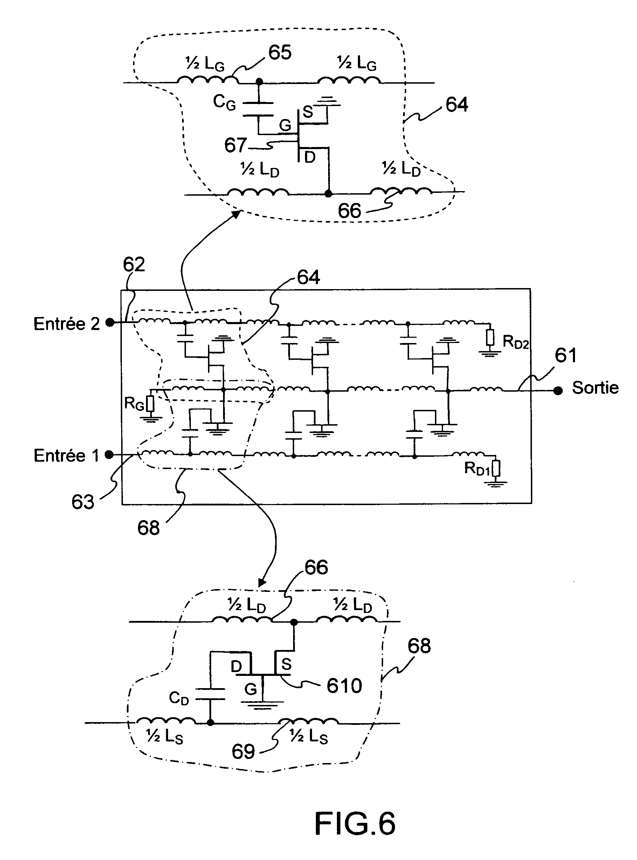

La première fonctionnalité consiste à fabriquer un signal différentiel à partir d'un signal référencé. Cette fonctionnalité se traduit par une division en deux de la puissance du signal d'entrée et la mise en opposition de phase des signaux issus de la division. La seconde fonctionnalité, réciproque de la première, consiste à transformer un signal différentiel en un signal référencé. Cette autre fonctionnalité se traduit par une combinaison du signal d'entrée avec un signal d'amplitude identique et de phase opposée. Ainsi, ces deux fonctionnalités peuvent être réalisées au moyen de deux structures actives, mais en utilisant deux structures remplissant des fonctionnalités différentes, d'une part un combineur, d'autre part un diviseur. Les figures 4 et 6 présentent le schéma de principe connu de ces deux structures réalisées à l'aide de structures actives réparties. Ce principe est notamment décrit dans le document [2] cité précédemment.

La figure 4 nous présente le schéma de principe d'un dispositif diviseur permettant d'obtenir à partir d'un signal d'entrée deux signaux d'amplitudes proches, voire sensiblement identiques, et de phases opposées. La structure connue de ce dispositif est une structure dérivée de celle d'un amplificateur à structure distribuée classique.
Comme on peut le constater sur la figure le diviseur présenté comporte deux structures distribuées partageant une même ligne d'entrée 41 sur laquelle est appliqué le signal d'entrée. La première structure est formée de la ligne d'entrée 41 et de la ligne 42 fournissant la sortie 1. La deuxième structure est formée de la ligne d'entrée 41 et de la ligne 43 fournissant la sortie 2.
Comme le montre la vue détaillée 44 la première structure est constituée de cellules élémentaires composées de deux inductances 45 de valeur 1/2 L_{D1} en série et de deux inductances 46 de valeur 1/2 L_{E} mises en série également.
Cette structure comporte de plus un élément actif 47 amplificateur, qui peut être par exemple un transistor à effet de champ en configuration "source commune" dont le drain D est relié au point commun des deux inductances 45 et dont la grille G est reliée au point commun des deux inductances 46.
De la même façon, comme le montre la vue détaillée 48 la deuxième structure distribuée est constituée de cellules élémentaires composées des deux inductances 46 de valeur ½ L_{E} mises en série et de deux inductances 49 de valeur ½ L_{D2} en série également. Cette structure comporte de plus, comme la première structure, un élément actif 410, amplificateur, qui peut par exemple être un transistor à effet de champ en configuration "grille commune" dont le drain D est relié au point commun des deux inductances 49 et dont la source S est reliée au point commun des deux inductances 46.
Ces structures élémentaires se répètent à l'identique un nombre N de fois pour former la structure complète. La structure globale du balun dans sa forme diviseur peut donc être considérée comme deux structures superposées. Dans le cas où l'élément actif est un transistor à effet de champ, la première structure peut être vue comme un ensemble de deux lignes couplées : une première ligne, appelée ligne de drain, formée de cellules LC constituées d'une inductance 45 et de la capacité C_{DS} du transistor à effet de champ 47 qui lui est associé, et une deuxième ligne, appelée ligne de grille, formée de cellules LC constituées d'une inductance 46 et de la capacité C_{GS} du même transistor à effet de champ 47. De même la deuxième structure peut être vue comme un ensemble de deux lignes couplées : une première ligne, appelée ligne de drain, formée de cellules LC constituées d'une inductance 49 et de la capacité C_{GD} du transistor à effet de champ 410 qui lui est associé, et une deuxième ligne, appelée ligne de source, formée de cellules LC constituées d'une inductance 46 et de la capacité C_{GS} du même transistor à effet de champ 410.
Le couplage entre lignes d'une même structure est ici un couplage "actif" qui fait intervenir les générateurs de courant que constituent les transistors à effet de champ qui entrent dans la constitution des cellules 44 et 48.
Comme on peut le constater sur la figure, le mode de fonctionnement des transistors 47 et 410 est différent. Les transistors 47 fonctionnent selon une configuration "source commune" qui procure, entre l'entrée et la sortie du transistor, un déphasage de 180° aux basses fréquences et un déphasage Φ + 180° aux hautes fréquences, alors que les transistors 410 fonctionne selon une configuration "grille commune" qui procure un déphasage nul aux basses fréquences et un déphasage Φ aux hautes fréquences.
Il est à noter que c'est cette différence dans les modes de fonctionnement qui permet à cette double structure distribuée de délivrer à partir d'un même signal d'entrée deux signaux d'amplitudes proches, en opposition de phase.

La figure 6 nous présente le schéma de principe d'un dispositif combineur permettant d'obtenir à partir de deux signaux d'entrée un signal de sortie qui représente le résultat de la combinaison en opposition de phase des signaux d'entrée. La structure connue de ce dispositif est, comme dans le cas de la figure 4, une structure dérivée de celle d'un amplificateur à structure distribuée classique. La structure du dispositif combineur est constituée de deux structures distribuées partageant une même ligne de sortie 61 qui délivre le signal combiné. La première structure est formée de la ligne d'entrée 62 et de la ligne 61. La deuxième structure est formée de la ligne d'entrée 63 et de la ligne 61.
Comme le montre la vue détaillée 64 la première structure est constituée de cellules élémentaires composées de deux inductances 65 de valeur 1/2 L_{G} en série et de deux inductances 66 de valeur 1/2 L_{D} mises en série également. Cette structure comporte de plus un élément actif 67, amplificateur, qui peut être un transistor à effet de champ en configuration "source commune" dont le drain D est relié au point commun des deux inductances 66 et dont la grille G est reliée au point commun des deux inductances 65.
De la même façon, comme le montre la vue détaillée 68 la deuxième structure distribuée est constituée de cellules élémentaires composées des deux inductances 66 de valeur 1/2 L_{D} mises en série et de deux inductances 69 de valeur 1/2 L_{S} en série également. Cette structure comporte de plus, comme la première structure, un élément actif 610 amplificateur, qui peur être un transistor à effet de champ en configuration "grille commune" dont le drain D est relié au point commun des deux inductances 66 et dont la source S est reliée au point commun des deux inductances 69.

La structure globale du balun dans sa forme combineur peut donc être considérée comme un ensemble de deux structures superposées. Dans le cas où l'élément actif est un transistor à effet de champ, la première structure peut être vue comme un ensemble de deux lignes couplées, une première ligne, appelée ligne de grille, formée de cellules LC constituées d'une inductance 65 et de la capacité C_{G} du transistor à effet de champ 67 qui lui est associé, et une deuxième ligne, appelée ligne de drain, formée de cellules LC constituées d'une inductance 66 et de la capacité C_{DS} du même transistor à effet de champ 67. De même la deuxième structure peut être vue comme un ensemble de deux lignes couplées une première ligne, appelée ligne de Source, formée de cellules LC constituées d'une inductance 69 et de la capacité Cₛ du transistor à effet de champ 610 qui lui est associé, et une deuxième ligne, appelée ligne de drain, formée de cellules LC constituées d'une inductance 66 et de la capacité C_{D} du même transistor à effet de champ 610.

Les illustrations des figures 4 et 6, permettent de constater que le schéma de structure d'un balun combineur peut être aisément déduit de celle du balun diviseur par permutation des lignes de grille et de drain d'un montage à l'autre. La structure distribuée classique permet donc de réaliser de manière simple deux montages remplissant les fonctionnalités remplies par un même balun passif. Ainsi par exemple, pour réaliser un circuit mélangeur de fréquence en circuit MMIC, on peut implanter sur les entrées RF et OL du mélangeur, des baluns de type diviseur, et un balun de type combineur sur la sortie FI du mélangeur, le mélangeur et les trois baluns étant ainsi réalisés sur le même composant intégré.

Dans les exemples illustrés par les figures 4 et 6, l'élément actif est constitué par un transistor à effet de champ. Bien évidemment, ceci ne représente nullement une limitation et tout autre élément actif approprié permettant de réaliser des montages ayant les caractéristiques des montages "grille commune" et "source commune", comme un transistor bipolaire par exemple peut être utilisé. Dans le cas d'e transistors bipolaires les configurations correspondantes sont respectivement les configurations "base commune" et "émetteur commun".

Les baluns réalisés à partir de structures distribuées classiques telles que celles illustrées sur les figures 4 et 6 permettent avantageusement d'obtenir un déphasage de 180° entre voies de bonne précision, typiquement de l'ordre de 3° pour des signaux à large bande passante, 4 à 18 GHz par exemple. En revanche leur utilisation présente certains inconvénients, parmi lesquels on peut citer d'une part la difficulté qu'il y a à équilibrer les gains des deux voies couplées à la voie commune, et d'autre part la difficulté à obtenir de bons coefficients de réflexion, en particulier en ce qui concerne les lignes de grille. La différence de gain entre voies conduit en particulier à considérer la voie ayant le gain le plus faible et à limiter le gain de l'autre voie à cette valeur. On limite ainsi le rendement du montage, le gain obtenu en pratique étant relativement faible, typiquement de l'ordre de 1 dB.

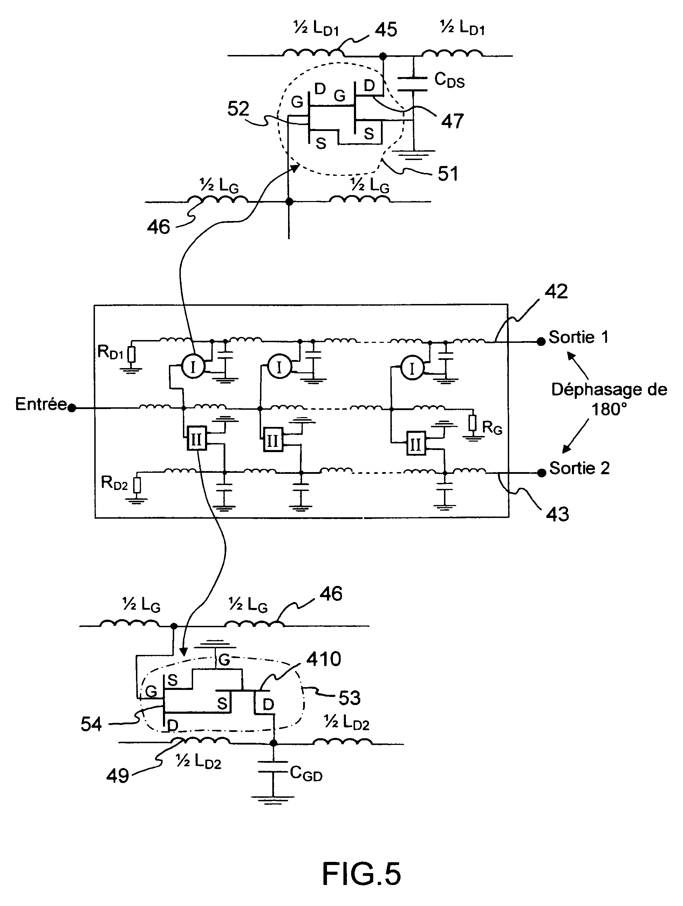

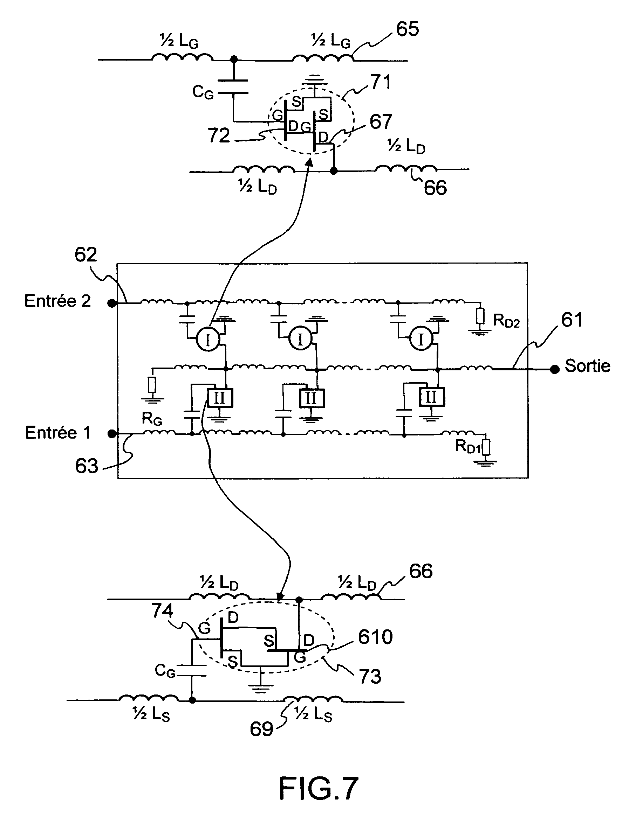

Pour pallier ces inconvénients, les baluns à large bande selon l'invention présentent une structure distribuée modifiée par rapport à la structure classique connue décrite précédemment. Cette structure modifiée est illustrée par les schémas de principe des figures 5 et 7.
Comme le montrent les figures 5 et 7, le balun modifié diffère du balun connu de l'art antérieur en ce que les cellules élémentaires comportent un deuxième transistor à effet de champ. Ce deuxième transistor est monté de façon à ce que chaque élément actif, lorsque celui-ci est réalisé au moyen de transistor à effet de champ, comporte deux transistors à effet de champ et présente en entrée une grille et en sortie un drain. De cette manière, chaque structure modifiée comporte une ligne de grille et une ligne de drain. De la sorte les deux structures d'un même balun présentent avantageusement des impédances d'entrée et de sortie sensiblement égales sans que le déphasage entre voies soit affecté.

La figure 5 présente le schéma de principe d'un balun diviseur réalisé autour de deux structures distribuées modifiées selon l'invention.
Comme on peut le constater le balun modifié selon l'invention diffère du balun connu illustré par la figure 4 en ce que les transistors 47 et 410 composant les cellules 44 et 48, ont été remplacés respectivement par les montages 51 (I) et 53 (II) dont des vues agrandies sont représentées.
Le montage 51 associe au transistor à effet de champ 47 monté en configuration "source commune" un deuxième transistor à effet de champ 52. La grille de ce transistor 52 est connectée au point commun entre les deux inductances 46, tandis que son drain est relié à la grille du transistor 47, les sources des deux transistors étant mises à la masse. Le montage ainsi réalisé se comporte comme un montage de type Darlington et la ligne de grille présente sensiblement l'impédance d'entrée d'une ligne composée de cellules LC cascadées, ces cellules étant constituées par l'inductance 46 égale à 1/2 L_{G} et la capacité grille-source C_{GS} du transistor 52.
Le montage 53, quant à lui, associe au transistor à effet de champ 410 monté en configuration "grille commune" un deuxième transistor à effet de champ 54. La grille de ce transistor 54 est connectée au point commun entre les deux inductances 46, tandis que son drain est relié à la source du transistor 410, la grille du transistor 54 et la source du transistor410 étant mises à la masse. Le drain du transistor 410 est quant à lui relié au point commun entre les deux inductances 49. Le montage ainsi réalisé se comporte comme un montage de type "Cascode" et la ligne de grille présente sensiblement l'impédance d'entrée d'une ligne composée de cellules LC cascadées, ces cellules étant constituées par l'inductance 46 égale à ½ L_{G} et la capacité grille-source C_{GS} du transistor 54.

Grâce à l'ajout dans chaque cellule d'un transistor monté en configuration "source commune", le balun selon l'invention comporte deux structures distribuées présentant des impédances d'entrée sensiblement identiques. Cette similitude des impédances d'entrée favorise avantageusement l'équilibrage des gains de chacune des voies de sortie 55 et 56 du diviseur. Elle permet également de réaliser un montage dont les caractéristiques de gain, de déphasage et d'impédance varient avantageusement de manière moindre sur la bande de fréquence sur laquelle est utilisé le balun.

La figure 7 présente le schéma de principe d'un balun combineur réalisé autour de deux structures distribuées modifiées selon l'invention. Comme dans le cas du balun diviseur selon l'invention, le balun combineur comporte des cellules élémentaires modifiées essentiellement par l'ajout d'un deuxième transistor à effet de champ monté en configuration "source commune", le transistor 72 pour la cellule 71 et le transistor 74 pour la cellule 73. De la même façon que dans le cas du balun diviseur, le balun combineur selon l'invention est ainsi constitué de cellule comportant soit un montage 71 de type "Darligton", soit un montage 72 de type "Cascode". Il présente ainsi les mêmes caractéristiques avantageuses que le balun diviseur selon l'invention.

Il est à noter que, comme dans le cas des exemples d'application illustrés par les figures 4 et 6, les éléments actifs des baluns selon l'invention ne sont pas limités aux seuls transistors à effet de champ et peuvent être notamment constitués par des transistors bipolaires.

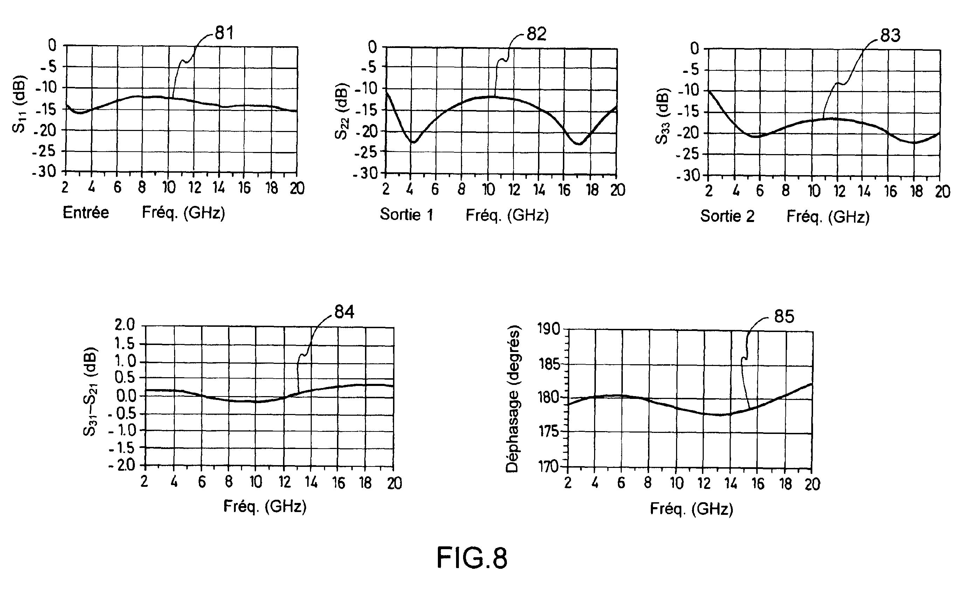

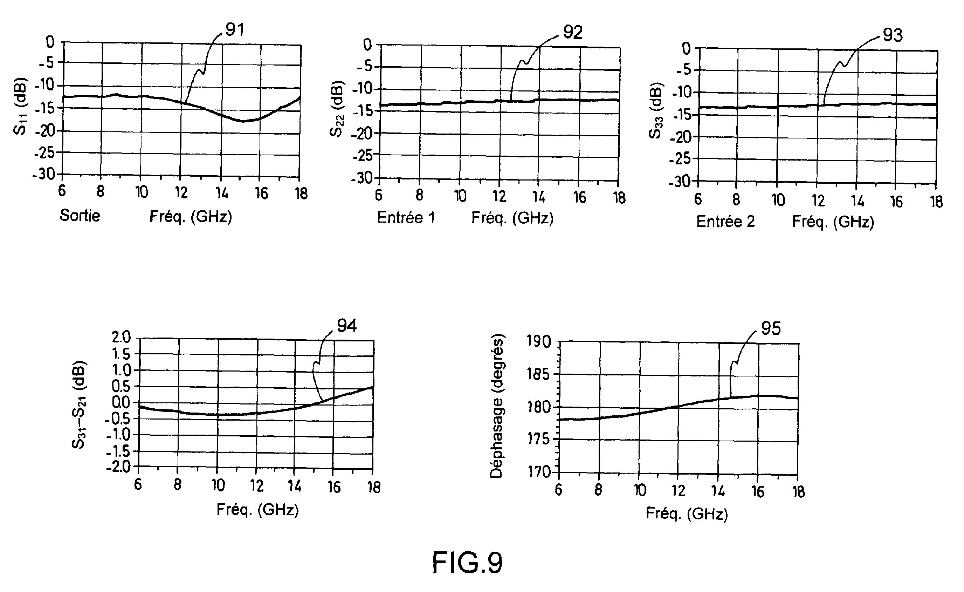

Les figures 8 et 9 représentent, respectivement pour le balun diviseur et pour le balun combineur selon l'invention, tels que ceux dont le schéma est présenté sur les figures 5 et 7, les courbes de variation en fonction de la fréquence des adaptations d'entrée et de sortie, ainsi que les courbes de variation de la différence de gain et du déphasage entre voies. Ces courbes qui résultent de l'étude du comportement en fréquence de modèles de simulation sont présentées ici, à titre d'exemple non limitatif des performances des baluns selon l'invention, pour illustrer le caractère avantageux de l'invention.

Les courbes de la figure 8 traduisent les résultats de simulations du comportement en fréquence d'un modèle de balun diviseur appliqué aux entrées RF et LO d'un dispositif mélangeur, les sorties du balun ayant été adaptées. La bande de fréquences explorée est ici une bande large s'étendant typiquement de 2GHz à 20GHz.
Les courbes 81, 82 et 83 montrent l'évolution en fonction de la fréquence du coefficient de réflexion de l'entrée du balun diviseur modélisé (courbe 81), ainsi que celle des coefficients de réflexion des sorties 1 et 2 (courbes 82 et 83). Comme on peut le constater, ces coefficients présentent sur la totalité de la bande passante explorée, une valeur maximum inférieure à -10 dB.
La courbe 84 montre l'évolution en fonction de la fréquence de la différence des gains entre les voies de sortie 1 et 2. Ainsi qu'on peut le constater sur la figure, cette différence reste avantageusement faible, typiquement inférieure à 0,5 dB, et sensiblement constante sur la totalité de la bande de fréquence explorée. Les gains étant ainsi uniformisés, il n'est avantageusement pas nécessaire de procéder à une limitation volontaire du gain de l'une ou l'autre des voies et l'on peut ainsi bénéficier dans une large mesure, grâce à l'invention, du gain procuré par les structures amplificatrices distribuées.
La courbe 85, quant à elle, montre l'évolution, en fonction de la fréquence, du déphasage entre voies, déphasage qui, comme on peut le constater reste sensiblement égale à 180° sur la totalité de la bande explorée.

Les courbes de la figure 9 traduisent les résultats de simulations du comportement en fréquence d'un modèle de balun combineur appliqué à la sortie FI d'un dispositif mélangeur, les entrées du balun ayant été adaptées sur une impédance caractéristique de 50 ohms. La bande de fréquences explorée est ici également une bande large s'étendant typiquement de 6GHz à 18GHz.

Les courbes 91, 92 et 93 montrent l'évolution en fonction de la fréquence du coefficient de réflexion de la sortie du balun combineur modélisé (courbe 91), ainsi que celle des coefficients de réflexion des entrées 1 et 2 (courbes 92 et 93). Comme on peut le constater, ces coefficients présentent, dans le cas du balun combineur, une variation maximum de l'ordre de 5 dB sur la totalité de la bande passante explorée et restent sensiblement inférieurs à -10dB sur toute la bande passante étudiée.

La courbe 94 montre l'évolution en fonction de la fréquence de la différence des gains entre les voies d'entrée 1 et 2. Ainsi qu'on peut le constater sur la figure, cette différence reste avantageusement faible, typiquement inférieure à 1 dB, et sensiblement constante sur la totalité de la bande de fréquence explorée. Les gains étant ainsi uniformisés, il n'est avantageusement pas nécessaire de procéder à une limitation volontaire du gain de l'une ou l'autre des voies et l'on peut ainsi bénéficier dans une large mesure, grâce à l'invention, du gain procuré par les structures amplificatrices distribuées.

La courbe 95, quant à elle, montre l'évolution, en fonction de la fréquence, du déphasage entre voies, déphasage qui, comme on peut le constater reste sensiblement égale à 180° sur la totalité de la bande explorée.

Ainsi, comme on peut le constater au travers des résultats illustrés par les figures 8 et 9 la structure de balun large bande selon l'invention, aussi bien en terme d'adaptation, qu'en termes de gain ou de déphasage, aussi bien dans sa forme diviseur que dans sa forme combineur, permet de réaliser des dispositifs pour lesquels les déphasages entre voies sont avantageusement constants et égaux à 180°, et pour lesquels les différences de gain entre voies sont minimisées.

## Revendications

1. Dispositif balun à large bande passante, comportant trois lignes (41, 42, 43), formant deux structures amplificatrices distribuées, chaque structure comportant une ligne (41) commune avec l'autre structure, chaque structure étant constituée de cellules élémentaires comportant chacune deux inductances (46) en série sur la ligne commune (41) et deux autres inductances ( 45, 49) en série sur l'autre ligne (42, 43) formant la structure, ainsi qu'un élément actif (51, 53) amplificateur relié d'une part au point commun des inductances (46) en série sur la ligne commune (41) et d'autre part au point commun des inductances (45, 49) en série sur l'autre ligne formant la structure,
**caractérisé en ce que** l'élément actif (51) de la première structure (41, 42) est constitué de deux transistors à effet de champ (47, 52) en configuration "source commune" agencés pour former un montage de type "Darlington" et que l'élément actif (53) de la seconde structure est constitué d'un transistor à effet de champ (54) en configuration "source commune" et d'un transistor à effet de champ (410) en configuration "grille commune" agencés pour former un montage de type Cascode".

2. Dispositif balun à large bande passante, comportant trois lignes (41, 42, 43), formant deux structures amplificatrices distribuées, chaque structure comportant une ligne (41) commune avec l'autre structure, chaque structure étant constituée de cellules élémentaires comportant chacune deux inductances (46) en série sur la ligne commune (41) et deux autres inductances ( 45, 49) en série sur l'autre ligne (42, 43) formant la structure, ainsi qu'un élément actif (51, 53) amplificateur relié d'une part au point commun des inductances (46) en série sur la ligne commune (41) et d'autre part au point commun des inductances (45, 49) en série sur l'autre ligne formant la structure,
**caractérisé en ce que** l'élément actif (51) de la première structure (41, 42) est constitué de deux transistors bipolaires (47, 52) en configuration "Emetteur commun" agencés pour former un montage de type "Darlington" et que l'élément actif (53) de la seconde structure est constitué d'un transistor bipolaire (54) en configuration "Emetteur commun" et d'un transistor bipolaire (410) en configuration "Base commune" agencés pour former un montage de type "Cascode".

## Claims

1. Broadband balun device, comprising three lines (41, 42, 43), forming two distributed amplifying structures, each structure comprising a line (41) common with the other structure, each structure consisting of elementary cells each comprising two inductors (46) in series on the common line (41) and two other inductors (45, 49) in series on the other line (42, 43) forming the structure, as well as an amplifying active element (51, 53) linked on the one hand to the common point of the inductors (46) in series on the common line (41) and on the other hand to the common point of the inductors (45, 49) in series on the other line forming the structure,
**characterized in that** the active element (51) of the first structure (41, 42) consists of two field-effect transistors (47, 52) in "common source" configuration designed to form an arrangement of "Darlington" type and that the active element (53) of the second structure consists of a field-effect transistor (54) in "common source" configuration and of a field-effect transistor (410) in "common gate" configuration designed to form an arrangement of "Cascode" type.

2. Broadband balun device, comprising three lines (41, 42, 43), forming two distributed amplifying structures, each structure comprising a line (41) common with the other structure, each structure consisting of elementary cells each comprising two inductors (46) in series on the common line (41) and two other inductors (45, 49) in series on the other line (42, 43) forming the structure, as well as an amplifying active element (51, 53) linked on the one hand to the common point of the inductors (46) in series on the common line (41) and on the other hand to the common point of the inductors (45, 49) in series on the other line forming the structure,
**characterized in that** the active element (51) of the first structure (41, 42) consists of two bipolar transistors (47, 52) in "common emitter" configuration designed to form an arrangement of "Darlington" type and that the active element (53) of the second structure consists of a bipolar transistor (54) in "common emitter" configuration and of a bipolar transistor (410) in "common base" configuration designed to form an arrangement of "Cascode" type.

## Patentansprüche

1. Breitband-Balun-Vorrichtung mit drei Leitungen (41, 42, 43), die zwei verteilte Verstärkungsstrukturen bilden, wobei jede Struktur eine Leitung (41) gemeinsam mit der anderen Struktur aufweist, wobei jede Struktur aus Elementarzellen besteht, die je zwei Drosselspulen (46) in Reihe auf der gemeinsamen Leitung (41) und zwei weitere Drosselspulen (45, 49) in Reihe auf der anderen Leitung (42, 43) aufweisen, die die Struktur bilden, sowie mit einem aktiven Verstärkungselement (51, 53), das einerseits mit dem gemeinsamen Punkt der Drosselspulen (46) in Reihe auf der gemeinsamen Leitung (41) und andererseits mit dem gemeinsamen Punkt der Drosselspulen (45, 49) in Reihe auf der anderen die Struktur bildenden Leitung verbunden ist,
**dadurch gekennzeichnet, dass** das aktive Element (51) der ersten Struktur (41, 42) aus zwei Feldeffekttransistoren (47, 52) in der Konfiguration "gemeinsame Source" besteht, die angeordnet sind, um eine "Darlington"-Schaltung zu bilden, und dass das aktive Element (53) der zweiten Struktur aus einem Feldeffekttransistor (54) in der Konfiguration "gemeinsame Source" und aus einem Feldeffekttransistor (410) in der Konfiguration "gemeinsames Gate" besteht, die angeordnet sind, um eine "Kaskoden"-Schaltung zu bilden.

2. Breitband-Balun-Vorrichtung mit drei Leitungen (41, 42, 43), die zwei verteilte Verstärkungsstrukturen bilden, wobei jede Struktur eine Leitung (41) gemeinsam mit der anderen Struktur aufweist, wobei jede Struktur aus Elementarzellen besteht, die je zwei Drosselspulen (46) in Reihe auf der gemeinsamen Leitung (41) und zwei weitere Drosselspulen (45, 49) in Reihe auf der anderen Leitung (42, 43) aufweisen, die die Struktur bilden, sowie mit einem aktiven Verstärkungselement (51, 53), das einerseits mit dem gemeinsamen Punkt der Drosselspulen (46) in Reihe auf der gemeinsamen Leitung (41) und andererseits mit dem gemeinsamen Punkt der Drosselspulen (45, 49) in Reihe auf der anderen die Struktur bildenden Leitung verbunden ist,
**dadurch gekennzeichnet, dass** das aktive Element (51) der ersten Struktur (41, 42) aus zwei Bipolartransistoren (47, 52) in der Konfiguration "gemeinsamer Emitter" besteht, die angeordnet sind, um eine "Darlington"-Schaltung zu bilden, und dass das aktive Element (53) der zweiten Struktur aus einem Bipolartransistor (54) in der Konfiguration "gemeinsamer Emitter" und aus einem Bipolartransistor (410) in der Konfiguration "gemeinsame Basis" besteht, die angeordnet sind, um eine "Kaskoden"-Schaltung zu bilden.
